# EUROPÄISCHE PATENTANMELDUNG

(11) **EP 0 764 838 A1**
(43) Veröffentlichungstag der Anmeldung: **26.03.1997**
(21) Anmeldenummer: 96105147.1
(22) Anmeldetag: 30.03.1996
(51) Int. Cl.: G01L 1/12, H01L 41/12

(54) **Magnetoelastische Kraftmesseinrichtung**

(30) Priorität: 22.09.1995 DE 19535164
(71) Anmelder: ROBERT BOSCH GMBH, 70442 Stuttgart (DE)
(72) Erfinder: Dobler, Klaus, Dr.-Ing., 70839 Gerlingen (DE); Hachtel, Hansjörg, Dipl.-Ing.(FH), 71287 Weissach (DE)

(57) **Zusammenfassung**

Bei einer Meßeinrichtung (10) wird mit Hilfe eines Stempels (11) eine Kraft N auf einen Kern (12) und auf einen diese umgebende Hülse (14) eingeleitet. Sowohl der Kern (12) als auch die Hülse (14) bestehen aus einem Material mit magnetoelastischen Eigenschaften. Im Kern (12) und in der Hülse (14) wird jeweils eine gleich große Stauchung bewirkt. Zwischen dem Kern (12) und der Hülse (14) befindet sich eine Meßspule (13). Durch Verwendung des Kerns (12) und der Hülse (14) wird ein relativ großes und gut auswertbares Meßsignal erzeugt.

## Beschreibung

### Stand der Technik

Die Erfindung geht aus von einer Meßeinrichtung zur Bestimmung einer mit Hilfe eines Stempels eingeleiteten Kraft nach der Gattung des Hauptanspruchs. Soll mit Hilfe einer Meßeinrichtung eine Kraft bestimmt werden, so wird bisher mit Hilfe eines Stempels diese Kraft auf einen Kern aus einem Material mit magnetoelastischen Eigenschaften eingeleitet. Der Kern ist von einer Meßspule umgeben. Aufgrund der eingeleiteten Kraft werden Änderungen der magnetischen und elektrischen Eigenschaften des Kernstoffs, insbesondere eine Änderung der Permeabilität, hervorgerufen, die durch die stromdurchflossene Spule erfaßt werden. Diese Meßeinrichtungen ergeben aber nur geringe auswertbare Meßsignale.

### Vorteile der Erfindung

Die erfindungsgemäße Meßeinrichtung mit den kennzeichnenden Merkmalen des Hauptanspruchs hat demgegenüber den Vorteil, daß relativ große Meßsignale erreicht werden. Die Magnetfeldausbildung wird verstärkt, so daß bei gleicher Spulengeometrie eine bessere magnetische Durchflutung der magnetoelastischen Legierung sowie eine Minderung des magnetischen Streuflusses erreicht wird.

### Zeichnung

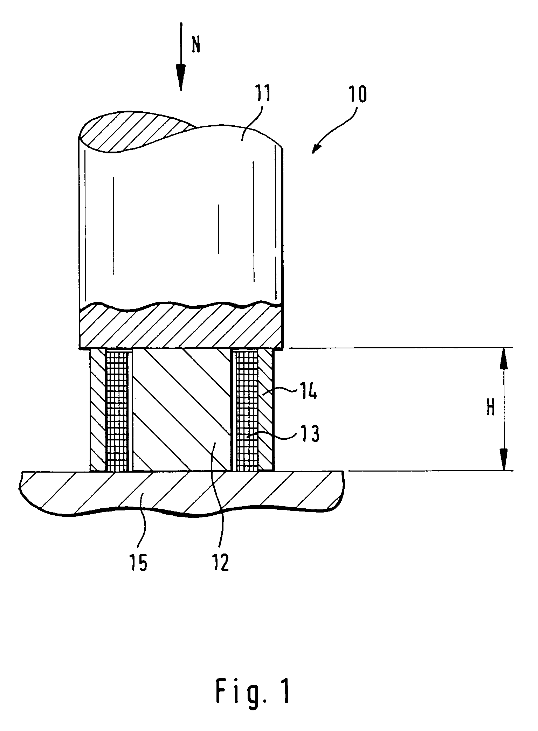

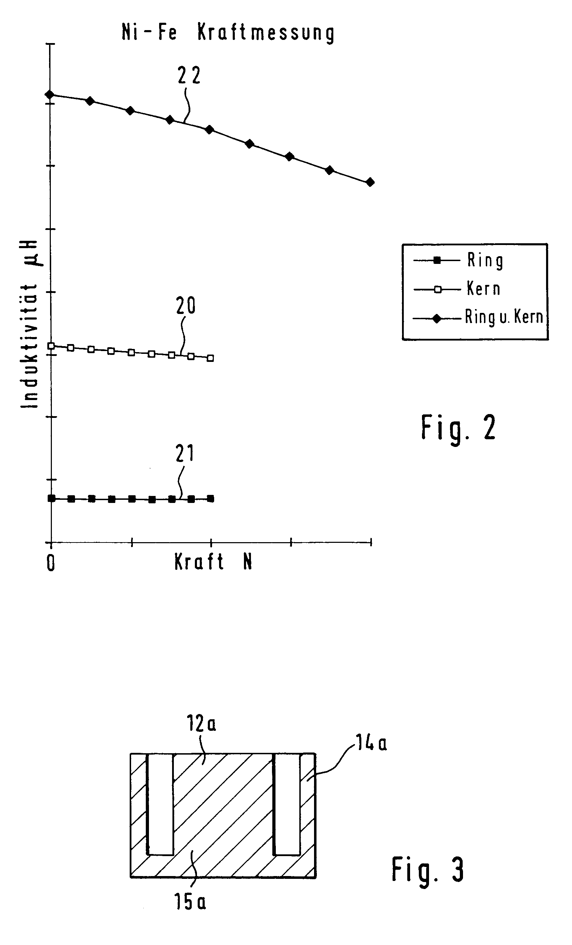

Ein Ausführungsbeispiel der Erfindung ist in der nachfolgenden Beschreibung und Zeichnung näher erläutert. In der Figur 1 ist ein Längsschnitt durch eine schematische Darstellung der Meßeinrichtung gezeigt. Die Figur 2 zeigt ein Diagramm des Verlaufs der Induktivität über der zu bestimmenden Kraft und Figur 3 eine Abwandlung nach Figur 1.

### Beschreibung des Ausführungsbeispiels

In der Figur 1 ist mit 10 eine Meßeinrichtung bezeichnet, bei der mit Hilfe eines Stempels 11 eine zu bestimmende Kraft N auf einen Kern 12 eingeleitet wird. Der Kern 12 besteht aus magnetoelastischem Material, insbesondere kann er aus Permalloylegierungen bestehen. In besonders vorteilhafter Weise wird der Kern im Sinterverfahren hergestellt. Der Kern 12 ist auf seiner Außenseite vorzugsweise über die gesamte Längsachse von einer Spule 13 umgeben. Ein als Hülse 14 ausgebildeter Ring umgreift die Spule 13. Der Kern 12 und die Hülse 14 liegen beide auf einer Bodenplatte 15 auf. Die Bodenplatte 15 ist möglichst plan ausgebildet und verläuft parallel zur Stirnfläche des Stempels 11.

Der Kern 12 und die Hülse 14 sind so ausgebildet, daß die über dem Stempel 11 eingeleitete Kraft N in beiden Bauteilen die gleiche Stauchung bewirkt. Vorteilhafterweise weisen der Kern 12 und die Hülse 14 hierzu in axialer Richtung gesehen dieselbe Höhe h auf. Ferner sollte bei gleicher Höhe h die Auflagefläche des Stempels 11 auf dem Kern 12 und auf der Hülse 14 ebenfalls gleich groß sein, so daß sich im Kern 12 und in der Hülse 14 eine gleich hohe Flächenpressung ergibt.

Die Meßeinrichtung arbeitet nach dem induktiven Meßverfahren. Um einen geschlossenen Magnetfluß zu ermöglichen, ist es hierbei notwendig, daß der Stempel 11 und die Bodenplatte 15 aus magnetisch leitendem Material, vorzugsweise aus ferromagnetischem Material bestehen. Die mit Hilfe des Stempels eingeleitete Kraft N bewirkt im Kern 12 bzw. in der Hülse 14 eine Änderung der magnetischen und elektrischen Eigenschaften, insbesondere eine Permeabilitätsänderung. Dadurch wird auch der von der Spule 13 erzeugte Magnetfluß verändert. Diese Veränderung des Magnetflusses bewirkt eine Rückkopplung auf die Spule 13, die sich in Form einer Induktivitätsänderung als Meßsignal auswirkt.

In der Figur 2 ist der Verlauf der Induktivitätsänderung in µ H über der zu messenden Kraft N dargestellt. Hierbei ist als Werkstoff für den Kern 12 bzw. für die Hülse 14 das Material NiFe (Eisen-Nickel-Legierung) verwendet worden, das in Sintertechnik hergestellt ist. Hierbei zeigt die Meßkurve 20, den Verlauf des Meßsignals wenn der Stempel 11 die Kraft N nur auf den Kern 12 einleiten würde. Hingegen zeigt die Meßkurve 21 den Meßverlauf, wenn der Stempel 11 die Kraft N nur auf die Hülse 14 einleitet. Wie aus der Figur 2 ersichtlich, bedeutet die gleichzeitige Verwendung des Kerns 12 und der Hülse 14 nicht eine Addition der Meßwerte der Kurve 20 und der Kurve 21, vielmehr werden die Meßwerte größer als ihre Summe. Der Verlauf der Meßkurve einer Meßeinrichtung bestehend aus dem Kern 12 und der Hülse 14 ist als Kurve 22 im Diagramm nach der Figur 2 eingezeichnet. Es ist ersichtlich, daß bei der Kraft Null die Induktivität ihren höchsten Wert hat und bei ansteigender Kraft abnimmt. Aufgrund der einwirkenden Kraft N wird somit die Induktivität µ H der Spule 13 reduziert, was ein deutlich sichtbares und auswertbares Meßsignal ergibt. Abhängig vom für den Kern 12 und der Hülse 14 verwendeten Material mit den magnetoelastischen Eigenschaften kann durch die einwirkende Kraft N die Permeabilität entweder vergrößert oder verkleinert werden, was entsprechend eine Erhöhung oder Reduzierung der Induktivität ergeben würde.

Selbstverständlich ist es auch möglich, den Stempel 11 und die Grundplatte 15 nicht vollständig aus ferrmomagnetischem Material herzustellen, sondern nur die Oberfläche oder den Randbereich mit ferromagnetischem Material zu beschichten. Ferner wäre es auch denkbar, zwischen einem Stempel und einer Grundplatte, wenn diese beiden Teile nicht aus ferromagnetischem Stoff bestehen, jeweils eine Scheibe aus ferromagnetischem Material dazwischenzulegen.

Wie oben erwähnt, muß für eine exakte Krafteinleitung die Stirnfläche des Stempels 11 parallel zur Oberfläche der Grundplatte 15 verlaufen, um somit eine möglichst senkrechte Krafteinleitung in den Kern 12 und in die Hülse 14 zu bewirken. In der Abwandlung des Ausführungsbeispiels nach der Figur 3 ist hierzu die Bodenplatte fest an dem Kern bzw. an der Hülse angebaut. Das eigentliche den Meßwert aufnehmende Meßelement besteht hierbei aus einem Festkörper, in den zur Aufnahme der Spule eine ringförmig verlaufende Ausnehmung ausgebildet ist. Dadurch dient der außen stehen bleibende Rand 14a als Hülse, während der innen stehen bleibende Festkörperteil 12a als Kern dient. Hierbei dient der Boden gleichzeitig als Bodenplatte bzw. Gegenelement 15a.

## Patentansprüche

1. Meßeinrichtung (10) zur Bestimmung einer mit Hilfe eines Stempels (11) auf ein aus magnetoelastischem Material bestehendes Meßelement (12) eingeleiteten Kraft N, wobei das Meßelement (12) mit einer Meßspule (13) in Wirkverbindung steht, dadurch gekennzeichnet, daß die Meßspule (13) vom Meßelement (12, 14) auf mindestens zwei Seiten umgeben ist.

2. Meßeinrichtung nach Anspruch 1, dadurch gekennzeichnet, daß die Meßspule (13) einen als erstes Meßelement dienenden Kern (12) umgreift und daß eine als zweites Meßelement dienende Hülse (14) die Meßspule (13) umgibt.

3. Meßeinrichtung nach Anspruch 1 und/oder 2, dadurch gekennzeichnet, daß der Stempel (11) im ersten (12) und im zweiten Meßelement (14) identische Stauchungen bewirkt.

4. Meßeinrichtung nach einem der Ansprüche 1 bis 3, dadurch gekennzeichnet, daß beide Meßelemente (12, 14) aus dem selben Material hergestellt sind.

5. Meßeinrichtung nach einem der Ansprüche 1 bis 4, dadurch gekennzeichnet, daß die dem Stempel (11) zugewandten Stirnflächen der beiden Meßelemente (12, 14) gleich groß sind.

6. Meßeinrichtung nach einem der Ansprüche 1 bis 5, dadurch gekennzeichnet, daß die beiden Meßelemente (12, 14) gleiche Höhe aufweisen.

7. Meßeinrichtung nach einem der Ansprüche 1 bis 6, dadurch gekennzeichnet, daß der Stempel (11) und eine Auflagefläche (15) der Meßelemente (12, 14) aus magnetisch leitendem Material bestehen.

8. Meßeinrichtung nach einem der Ansprüche 1 bis 6, dadurch gekennzeichnet, daß zwischen dem Stempel (11) und den Meßelementen (12, 14) und zwischen den Meßelementen (12, 14) und der Auflagefläche (15) Elemente aus ferromagnetischem Material angeordnet sind.

9. Meßeinrichtung nach einem der Ansprüche 1 bis 8, dadurch gekennzeichnet, daß die Meßelemente (12, 14) aus einer durch Sintern hergestellten Permalloylegierung bestehen.
